# EUROPÄISCHE PATENTSCHRIFT

(11) **EP 3 271 927 B1**
(45) Veröffentlichungstag und Bekanntmachung des Hinweises auf die Patenterteilung: **26.06.2019**
(21) Anmeldenummer: 15722178.9
(22) Anmeldetag: 11.05.2015
(51) Int. Cl.: H01C 7/12, H01C 7/108

(54) **ÜBERSPANNUNGSABLEITERSYSTEM**
OVERVOLTAGE ARRESTER SYSTEM
SYSTÈME DE PARAFOUDRE

(43) Veröffentlichungstag der Anmeldung: 24.01.2018
(73) Patentinhaber: Siemens Aktiengesellschaft, 80333 München (DE)
(72) Erfinder: PREIDEL, Axel, 91054 Buckenhof (DE)
(86) Internationale Anmeldenummer: PCT/EP2015/060311
(87) Internationale Veröffentlichungsnummer: WO 2016/180461

(56) Entgegenhaltungen:
- EP-A1- 1 494 284
- EP-A2- 0 537 486
- US-A- 4 326 232

## Beschreibung

Die Erfindung betrifft ein Überspannungsableitersystem zum Schutz einer elektrischen Anlage vor einer Überspannung oder unzulässigen Energiemenge, umfassend einen ersten Metalloxidableiter in einem ersten Strompfad und einen zweiten Metalloxidableiter in einen zweiten, zum ersten Strompfad parallel geschalteten Strompfad. Ein solches System ist aus der Europäischen Patentanmeldung EP 0 537 486 A2 bekannt.

Überspannungsableiter - kurz: Ableiter - werden in elektrischen Anlagen benutzt, um diese vor unerwünschten Energiemengen zu schützen, die sich im Allgemeinen als eine unzulässig hohe Spannung äußern. Unter einer elektrischen Anlage wird hierbei auch jedwedes elektrische Gerät oder Bauelement verstanden. So kann z. B. der Ableiter die in einer Leitung gespeicherte induktive Energie in Wärme umwandeln, um zu verhindern, dass sich in einem parallelen Schalter die Energie durch einen lange brennenden Lichtbogen in Wärme verwandelt und dadurch den Schalter zerstört.

Als Ableiter sind zwar immer noch Funkenstreckenableiter mit Ableitwiderständen aus Siliziumkarbid (SiC) im Einsatz, für den Neueinsatz kommen heute jedoch nur noch funkenstreckenlose Metalloxid-(MO-)Ableiter, das heißt Ableiter mit Ableitwiderständen aus Metalloxid (Metalloxid- oder MO-Widerständen) zur Anwendung. Ein MO-Ableiter realisiert den Schutz der elektrischen Anlage, indem die übermäßige Energiemenge im Ableiter in Wärme gewandelt wird. Der MO-Ableiter wird dabei parallel zum zu schützenden Anlagenteil geschaltet.

In Abhängigkeit der erwarteten, übermäßigen Energiemenge muss sichergestellt werden, dass der MO-Ableiter diese Energiemenge aufnehmen kann. Das aktive Material des MO-Ableiters (der Aktivteil) sind Scheiben aus einem Metalloxid, die ein bestimmtes Energieaufnahmevermögen pro Volumeneinheit (Energieaufnahmedichte) besitzen. Steigt die Energiemenge, die vom MO-Ableiter aufzunehmen ist, so muss - bei gleichbleibendem Material - das Volumen des Aktivteils erhöht werden. Wird damit gerechnet, dass ein Energieeintrag häufig, z. B. in Form aufeinanderfolgender Impulse auftritt, so kann das ebenfalls dazu führen, dass das Aktivteil-Volumen erhöht werden muss.

Für die Erhöhung des Aktivteil-Volumens kommt zunächst eine Reihenschaltung von Scheiben in Frage. Die Reihenschaltung der Scheiben im Aktivteil (Ableitersäule) führt zu einer tendenziell steigenden Spannung über dem MO-Ableiter für den Moment, wenn Energie dort in Wärme gewandelt wird. Steigert man die Anzahl der Scheiben in Reihe beliebig, so kann das ebenfalls zu einer unzulässig hohen Spannung an den zu schützenden Anlagenteilen führen. Mit zunehmender Häufigkeit des Energieeintrags im MO-Ableiter und zunehmender, übermäßiger Energie bei begrenzter Zahl der Scheiben in Reihe (Säulenhöhe), kann das erforderliche Energieaufnahmevermögen daher häufig nur durch Parallelschaltung von Ableitersäulen erhöht werden, wenn die anderen Randbedingungen sonst gleich bleiben.

Bei mehreren einzelnen, unmittelbar aufeinander folgenden Energieeinträgen (Impulsen) ergibt sich so eine Anzahl von benötigten, parallelen Ableitersäulen, die in der Regel der Gesamtanzahl der zu berücksichtigenden Einzelimpulse proportional ist. Hierbei ergibt sich jedoch das Problem, dass mit zunehmender Anzahl von parallelen Ableitersäulen - bei gleichbleibendem Gesamtstrom - der Strom pro Ableitersäule abnimmt. Damit sinkt auch die Stromdichte in den Säulen. Wie auch in der Publikation: CIGRE Technical Brochure 544: "Metal Oxide (MO) Surge Arresters - Stresses and Test procedures", Kapitel 3.4.2.5 berichtet wird, ist das Energieaufnahmevermögen der verwendeten Scheiben aber von der Stromdichte in den Ableitersäulen abhängig: Mit höherer Stromdichte steigt das Energieaufnahmevermögen. Im Umkehrschluss steigt aber damit die Wahrscheinlichkeit eines Ableiterausfalls mit sinkender Stromdichte, d. h. insbesondere auch bei der Parallelschaltung vieler Ableitersäulen.

Es ist daher Aufgabe der Erfindung, ein Überspannungsableitersystem der eingangs genannten Art anzugeben, welches sich zur Ableitung besonders hoher Energiemengen insbesondere aus impulsartigen Energieeinträgen eignet und gleichzeitig besonders ausfallsicher ist.

Diese Aufgabe wird erfindungsgemäß dadurch gelöst, dass eine Spannungs-Strom-Kennlinie des ersten Metalloxidableiters in einem Strombereich bei gleichem Strom eine niedrigere Spannung aufweist als eine Spannungs-Strom-Kennlinie des zweiten Metalloxidableiters, und der erste Strompfad einen Schalter aufweist.

Die Erfindung geht von der Überlegung aus, dass eine besonders ausfallsichere Konstruktion dann möglich wäre, wenn trotz der parallelen Metalloxidableiter der Strom durch den einzelnen Metalloxidableiter ausreichend groß bleibt. Mit anderen Worten: Insbesondere bei wenigen, impulsartigen, in kurzem zeitlichen Abstand auftretenden Energieeinträgen kann das verfügbare Energieaufnahmevermögen der Gesamtzahl der Ableitersäulen und die Stromdichte je Ableitersäule erhöht werden, wenn man den Gesamtstrom nur dem Teil der parallelen Säulen zuführt, der das benötigte Energieaufnahmevermögen für z. B. einen einzelnen Impuls abdeckt. Es könnte auch ein Teil sein, der mehrere Impulse abdeckt. Um den Gesamtstrom nur einem Teil der Ableitersäulen gezielt zuführen zu können, wird die nichtlineare Spannungs-Strom-Kennlinie der Ableitersäulen genutzt: Sie bedingt bei nur geringen Unterschieden zwischen zwei Spannungen auf der Kennlinie große Unterschiede in den zugehörigen Strömen. Dies wird bei der Koordinierung der Stromaufteilung bei Ableitern, die aus mehreren Säulen bestehen, eigentlich als Nachteil angesehen, kann aber bei der hier vorgeschlagenen Anwendung ausgenutzt werden: Wird nämlich ein Metalloxidableiter so gebaut, dass seine Spannungs-Strom-Kennlinie in einem Strombereich bei gleichem Strom eine niedrigere Spannung aufweist als die Spannungs-Strom-Kennlinie des anderen Metalloxidableiters, so wird der Metalloxidableiter mit der geringfügig niedrigeren Spannung einen wesentlich größeren Strom erfahren. Ist das Energieaufnahmevermögen dieses Ableiters erschöpft, sollte der Stromfluss zu diesem Ableiter unterbrochen werden. Dies erfolgt durch einen Schalter in dessen Strompfad. Dadurch erfolgt ein Stromfluss in der Folge nur noch in den anderen, unbelasteten Metalloxidableiter. Unter einem Schalter wird hierbei jedwede Schalteinheit verstanden, die geeignet ist, um den Stromfluss durch die Leitung zu unterbrechen, umzuleiten (zu kommutieren) oder zu verhindern.

In vorteilhafter Ausgestaltung umfasst das Überspannungsableitersystem eine Anzahl weiterer Metalloxidableiter in jeweils einem, zum ersten und zweiten Strompfad parallel geschalteten weiteren Strompfad, wobei die Spannungs-Strom-Kennlinien der weiteren Metalloxidableiter in dem Strombereich bei gleichem Strom sukzessive niedrigere Spannungen, d. h. schrittweise, z. B. in gleichmäßigen Abständen niedrigere Spannungen aufweisen, und wobei der jeweilige weitere Strompfad jeweils einen Schalter aufweist. Durch weitere parallele, abtrennbare Strompfade mit Ableitern wird das Gesamtenergieaufnahmevermögen weiter erhöht. Durch die sukzessiv niedrigere Spannungs-Strom-Kennlinie wird gewährleistet, dass unabhängig von der Stellung der Schalter nur in einem Strompfad ein deutlich größerer Strom fließt als in den anderen Strompfaden. Durch die stufenweise niedrigeren Spannungs-Strom-Kennlinien gibt es nämlich bei jeder Schalterstellung genau einen Ableiter, dessen Spannungs-Strom-Kennlinie am niedrigsten ist.

Zur Automatisierung des Vorgangs ist dabei dem jeweiligen Schalter eines Strompfades vorteilhafterweise eine Steuerungseinrichtung zugeordnet, die dafür ausgelegt ist, den Schalter zu öffnen, wenn der Metalloxidableiter des jeweiligen Strompfads des Schalters eine vorgegebene Energiemenge aufgenommen hat. Die Steuerungseinrichtung öffnet also den Schalter und trennt damit den Strompfad zu einem bestimmten Metalloxidableiter, wenn dessen Energieaufnahmevermögen erschöpft ist. Hierbei kann auch für alle Metalloxidableiter des Überspannungsableitersystems eine gemeinsame Steuerungseinrichtung vorgesehen sein, die alle Schaltvorgänge zentralisiert steuert.

Schalter und/oder Steuerungseinrichtung weisen dabei vorteilhafterweise einen niederohmigen und/oder niederinduktiven Aufbau auf, d. h. ihre Induktivität und ihr Widerstand sind vergleichsweise niedrig. Dies bedeutet, dass Induktivität und/oder Widerstand so niedrig sind, dass die beabsichtigte Wirkung des Abstandes der beiden Spannungs-Strom-Kennlinien gesichert bleibt, d. h. der Schalter nicht verhindert, dass der Stromfluss bei geschlossenem Schalter vorwiegend durch den Metalloxidableiter im Strompfad des Schalters läuft.

Zur Ermittlung der Energieaufnahme der jeweiligen Metalloxidableiter umfasst das Überspannungsableitersystem in einer ersten vorteilhaften Ausgestaltung eine in dem Strompfad des jeweiligen Schalters angeordnete Strom- und/oder Spannungsmesseinrichtung auf, wobei die dem Schalter zugeordnete Steuerungseinrichtung dafür ausgelegt ist, die dem Metalloxidableiter des Strompfads des Schalters zugeführte Energiemenge anhand der in der Strom- und/oder Spannungsmesseinrichtung gemessenen Werte zu ermitteln. Beispielsweise könnte in der Spannungsmesseinrichtung eine Funktion oder Kennlinie hinterlegt sein, die die zugeführte Energiemenge anhand der Spannungs- und/oder Stromverläufe durch den Metalloxidableiter ermittelt.

In einer zweiten, alternativen oder zusätzlichen Ausgestaltung des Überspannungsableitersystems umfasst dieses eine in dem jeweiligen Metalloxidableiter angeordnete Temperaturmesseinrichtung, wobei die dem Schalter des Strompfads des Metalloxidableiter zugeordnete Steuerungseinrichtung dafür ausgelegt ist, die dem Metalloxidableiter zugeführte Energiemenge anhand der in der Temperaturmesseinrichtung gemessenen Werte zu ermitteln. Übersteigt nämlich die Temperatur des Metalloxidableiters einen bestimmten Wert, kann hieraus eine zu hohe Energieaufnahme geschlossen werden.

Der Strombereich, in dem sich die Spannungs-Strom-Kennlinien hinsichtlich ihrer Spannung unterscheiden, liegt vorteilhafterweise zwischen 0,1 kA und 10 kA, vorzugsweise zwischen 0,001 kA und 100 kA. Dies ist so zu verstehen, dass die Spannungs-Strom-Kennlinien sich in dem gesamten jeweils benannten Bereich hinsichtlich ihrer Spannungen unterscheiden. Dies sind typische Größenordnungen für den Betrieb von Überspannungsableitern. Allgemein sollte der Strombereich vorteilhafterweise den gesamten Arbeitsstrombereich des Ableiters umfassen.

Der Spannungsunterschied der Spannungs-Strom-Kennlinie zweier Metalloxidableiter in diesem Bereich beträgt dabei mindestens 1 kV bei gleichem Strom. Hierdurch wird ein ausreichend unterschiedlicher Stromfluss bei einer Parallelschaltung erreicht.

Das hier vorgeschlagene System kann auch in Kombination mit einer konventionellen Parallelschaltung genutzt werden: Hierzu umfasst einer der bislang beschriebenen Metalloxidableiter eine Mehrzahl von parallel geschalteten Metalloxidableitereinheiten. Vorteilhafterweise kann hierbei jeder Metalloxidableiter gleich aufgebaut sein, d. h. jeder Ableiter besteht aus einer gleichen Anzahl gleichartiger Metalloxidableitereinheiten. Der Stromfluss wird dabei nicht auf eine einzelne Ableitersäule, sondern auf eine parallel geschaltete Gruppe von Ableitersäulen, die jeweils eine Ableitereinheit bilden, verteilt. Bei Erreichen der maximalen Energiemenge in der Gruppe wird der Stromfluss durch die gesamte Gruppe über den Schalter in ihrem Strompfad unterbrochen.

Eine Anordnung mit einer elektrischen Anlage umfasst vorteilhafterweise ein der elektrischen Anlage parallel geschaltetes, oben beschriebenes Überspannungsableitersystem.

Die mit der Erfindung erzielten Vorteile bestehen insbesondere darin, dass durch die Spannungsdifferenz in den Spannungs-Strom-Kennlinien zweier Metalloxidableiter oder - gruppen in Verbindung mit einer bedarfsweisen Leitungstrennung ein serieller Energieeintrag in verschiedene Metalloxidableiter erfolgt und so das Gesamtenergieaufnahmevermögen des Systems erhöht wird. Das System wird ausfallsicherer und kann hohe Energiemengen aufnehmen.

Ein Ausführungsbeispiel der Erfindung wird anhand von Zeichnungen näher erläutert. Darin zeigen:
- FIG 1: ein Überspannungsableitersystem mit zwei parallel geschalteten Metalloxidableitern und geschlossenem Schalter in einem Strompfad,
- FIG 2: das Überspannungsableitersystem mit geöffnetem Schalter in dem Strompfad,
- FIG 3: die Spannungs-Strom-Kennlinien der Metalloxidableiter aus dem Überspannungsableitersystem, und
- FIG 4: eine Metalloxidableitereinheit im Teilschnitt.

Gleiche Teile sind in allen Zeichnungen mit denselben Bezugszeichen versehen.

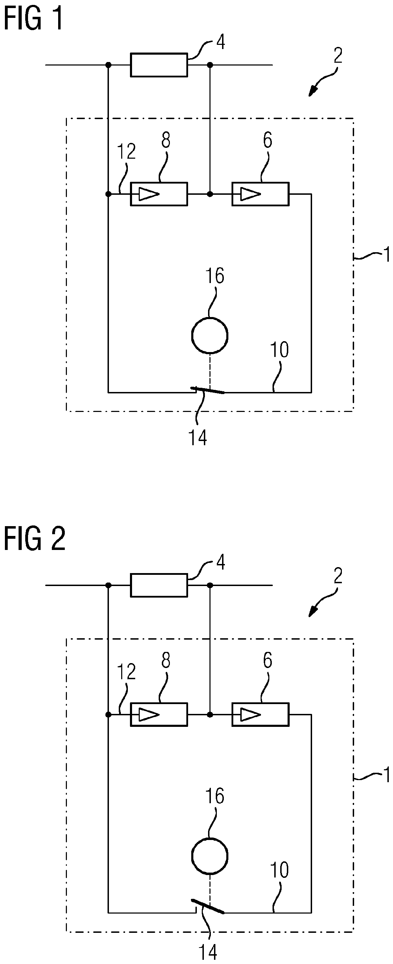

Die FIG 1 zeigt ein Überspannungsableitersystem 1 in einer Anordnung 2 mit einer elektrischen Anlage 4. Das Überspannungsableitersystem 1 soll die elektrische Anlage 4 vor Überspannungen schützen. Hiermit sind z. B. Blitz- oder Schaltüberspannungen gemeint, denen die Geräteisolation von elektrischen Anlagen 4 wie z. B. Leistungstransformatoren oder Messwandler nicht mehr gewachsen ist. Dazu ist das Überspannungsableitersystem 1 der elektrischen Anlage 4 parallel geschaltet, um die z. B. durch Blitz- oder Schaltüberspannungen entstehenden Ströme aufzunehmen. Das Überspannungsableitersystem 1 umfasst einen ersten Metalloxidableiter 6 und einen zweiten Metalloxidableiter 8, die in parallelen Strompfaden 10, 12 angeordnet sind.

Die Metalloxidableiter 6, 8 können selbst aus nur einer Metalloxidableitereinheit bestehen, oder aber selbst Gruppen von mehreren Metalloxidableitereinheiten darstellen, die einander parallel geschaltet sind. Der Strompfad 10 des ersten Metalloxidableiters 6 weist einen Schalter 14 auf, der von einer Steuerungseinrichtung 16 automatisiert geöffnet oder geschlossen werden kann. Der Schalter 14 kann auf vielerlei Art ausgestaltet sein, es kann z. B. ein einfacher mechanischer Schalter verwendet werden, aber auch Halbleiterschalter wie z. B. Thyristoren. In der FIG 1 ist der geschlossene Schalterzustand dargestellt. FIG 2 zeigt die Anordnung 2 aus FIG 1 mit geöffnetem Schalter 14.

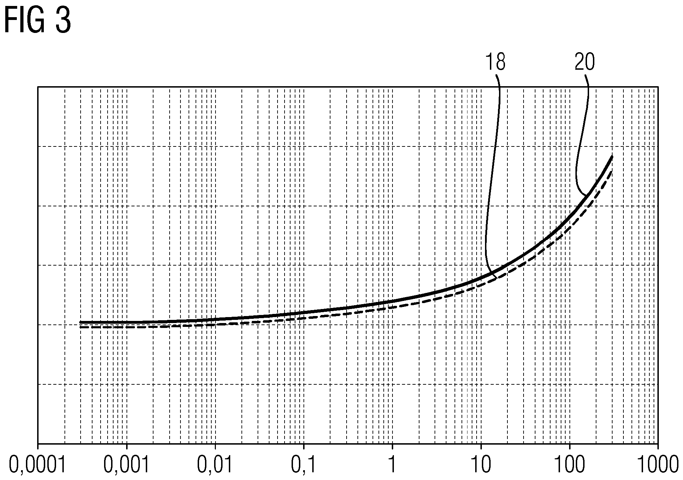

FIG 3 zeigt die Spannungs-Strom-Kennlinien 18, 20 der Metalloxidableiter 6, 8 des Überspannungsableitersystems 1. Die Abszisse zeigt den Strom in logarithmischer Skala in der Einheit Kiloampere (kA) von 0,0001 bis 1000 kA. Die Ordinate zeigt die Spannung, ist jedoch nicht mit absoluten Werten versehen, da diese für die Darstellung der Erfindung nicht von Belang sind. Die waagerechten Linien weisen aber einen Abstand von 100 Kilovolt (kV) auf.

Die Spannungs-Strom-Kennlinien 18, 20 der beiden Metalloxidableiter 6, 8 sind in einem Bereich von 0,0003 kA bis 300 kA dargestellt. Sie weisen mit steigender Spannung eine stark ansteigende Steigung auf. Diese extrem nicht-lineare Spannungs-Strom-Kennlinie stellt die charakteristische Eigenschaft von Metalloxidwiderständen dar und macht eine Abtrennung des Widerstandes durch Serienfunkenstrecken vom Netz, wie sie bei den früher verwendeten Ableitern mit SiC-Widerständen noch zwingend erforderlich war, überflüssig. Die im Bereich der möglichen anliegenden betriebsfrequenten Spannungen fließenden Ströme sind nämlich so klein, dass der Ableiter sich fast wie ein Isolator verhält. Werden dem Ableiter dagegen Stoßströme im Kiloampere-Bereich eingeprägt, wie es beim Auftreten von Blitz- oder Schaltüberspannungen der Fall ist, bleibt die resultierende Spannung an seinen Anschlussklemmen niedrig genug, um die Isolation der zugeordneten Betriebsmittel, d. h. hier der elektrischen Anlage 4 vor den Auswirkungen der Überspannungen zu schützen.

FIG 3 zeigt aber zudem, dass sich die Spannungs-Strom-Kennlinien der beiden Metalloxidableiter 6, 8 geringfügig unterscheiden. Über den gesamten dargestellten Strombereich unterscheiden sich die Spannungen um fast 10 kV bei gleichem Strom. Die Spannungs-Strom-Kennlinie 18 mit den jeweils niedrigeren Spannungen bei gleichem Strom ist diejenige des Metalloxidableiters 6 im Strompfad 10 mit dem Schalter 14. Die Spannungs-Strom-Kennlinie 20 ist diejenige des Metalloxidableiters 8 im Strompfad 12.

Die Funktionsweise des Überspannungsableitersystems 1 wird im Folgenden erläutert: Im Standardbetriebszustand ist zunächst der Schaltzustand der FIG 1 aktiv, d. h. der Schalter 14 ist geschlossen. Beim ersten Energieeintrag oder anfänglichen mehreren Energieeinträgen sind die beiden Metalloxidableiter 6, 8 mit den leicht unterschiedlichen Spannungs-Strom-Kennlinien 18, 20 parallelgeschaltet. Durch die unterschiedlichen Spannungs-Strom-Kennlinien 18, 20 werden sich bei einem Energieeintrag (Impuls) in die Parallelschaltung der Metalloxidableiter 6, 8 die Ströme in den beiden Metalloxidableitern 6, 8 stark unterscheiden: Der Metalloxidableiter 6 mit der geringfügig kleineren Spannung (Spannungs-Strom-Kennlinie 18) sieht einen viel größeren Strom. Der Metalloxidableiter 8 mit der leicht höheren Spannung (Spannungs-Strom-Kennlinie 20) wird nur einen sehr kleinen Strom sehen. Mit anderen Worten gesagt, wird durch den Metalloxidableiter 6 mit der geringfügig kleineren Spannung (Spannungs-Strom-Kennlinie 18) ein viel größerer Strom fließen als durch den Metalloxidableiter 8 mit der leicht höheren Spannung (Spannungs-Strom-Kennlinie 20) .

Ein niederohmiger und niederinduktiver Strompfad des Schalters 14 und der Steuerungseinrichtung 16 und deren Zuleitungen sichert die beabsichtigte Wirkung des Abstandes der beiden Spannungs-Strom-Kennlinien 18, 20. Durch die verschiedenen Kennlinien wird sich eine sehr unterschiedliche Stromaufteilung ergeben. Der Energieeintrag konzentriert sich nämlich auf den Metalloxidableiter 6.

Setzt sich der Energieeintrag fort, wird daher der Metalloxidableiter 6 zu einem Zeitpunkt sein zulässiges Energieaufnahmevermögen erreichen. Hierunter werden in der Regel zwei unterschiedliche Aspekte verstanden: Die während eines einmaligen Ableitvorganges schlagartig in den Ableiter eingebrachte Energie darf einen Wert nicht überschreiten, bei dem die Metalloxid-Widerstände thermomechanisch überlastet werden. Sinnvollerweise spricht man in diesem Zusammenhang vom Einzelimpuls-Energieaufnahmevermögen des Ableiters. Die Belastbarkeitsgrenze ist dadurch gegeben, dass eine innerhalb weniger Mikro- oder Millisekunden eingebrachte hohe Energie sprungartige Temperaturerhöhungen und damit verbunden extrem hohe mechanische Zug- und Druckbeanspruchungen der Keramik der MO-Widerstände bewirkt. Das kann zu Rissbildung oder im Extremfall sogar zum Bruch der Keramik führen.

Ganz andere Zusammenhänge gelten für das thermische Energieaufnahmevermögen: Dieses ist als diejenige maximal zulässige Energie definiert, die in den Ableiter eingebracht werden kann, so dass er anschließend noch wieder auf seine normale Dauerbetriebstemperatur abkühlen kann. Die im Ableiter unter Einwirkung der anliegenden betriebsfrequenten Spannung umgesetzte elektrische Verlustleistung ist nämlich stark temperaturabhängig. Mit wachsender Temperatur der MO-Widerstände steigt sie überproportional an. Demgegenüber kann der Ableiter konstruktionsbedingt aber nur eine bestimmte Wärmeleistung an die Umgebung abführen. Zwar nimmt auch dieser Wert mit der bei konstanter Umgebungstemperatur mit der Ableitertemperatur zu, jedoch längst nicht so stark wie die elektrische Verlustleistung. Übersteigt die elektrische Verlustleistung die abführbare Wärmeleistung, kann die Verlustleistung nicht mehr abgeführt werden. Der Ableiter wird dann thermisch instabil und heizt sich bis zur Selbstzerstörung auf. Dieser Schnittpunkt stellt daher die thermische Stabilitätsgrenze des Ableiters dar.

Das thermische Energieaufnahmevermögen wird so angegeben, dass die damit verbundene Temperaturerhöhung den Ableiter auf eine Temperatur bringt, die zur thermischen Stabilitätsgrenze einen ausreichenden Sicherheitsabstand aufweist. Die thermische Stabilitätsgrenze ist von Konstruktion zu Konstruktion unterschiedlich und kann z. B. bei Werten von etwa 190 °C bis 220 °C liegen.

Ist nun eines der beiden zulässigen (Einzelimpuls- oder thermisches) Energieaufnahmevermögen des Metalloxidableiters 6 erschöpft, so wird mittels der Steuerungseinrichtung 16 die Konfiguration der Metalloxidableiter 8 gemäß FIG 2 geändert. Der Schalter 14 wird also geöffnet. Dadurch ist ein Stromfluss durch den belasteten Metalloxidableiter 6 im Strompfad 10 nicht mehr möglich. Dadurch sieht in der Folge nur noch der bislang quasi unbelastete Metalloxidableiter 8 mit der Kennlinie 20 weitere Energieeinträge. Mit anderen Worten gesagt, finden in der Folge weitere Energieeinträge nur noch in den bislang quasi unbelasteten Metalloxidableiter 8 (mit der Kennlinie 20) statt.

Die Steuerungseinrichtung 16 ermittelt das Erreichen des zulässigen Energieaufnahmevermögens mittels nicht näher dargestellter Strom- und/oder Spannungsmesseinrichtungen im Strompfad 10 oder aber mittels einer Temperaturmesseinrichtung am Ableiter 6. Ebenso kann die Steuerungseinrichtung 16 dazu ausgebildet sein zu erkennen, welches Energieaufnahmevermögen erreicht oder gar überschritten war:

War das Einzelimpuls-Energieaufnahmevermögen des Metalloxidableiters 6 überschritten und sind Schäden am Metalloxidableiter 6 zu befürchten, so kann der Schalter 14 bis zur nächsten Wartung geöffnet bleiben. Alternativ kann die Wartung durch die Verwendung von Trennern während des laufenden Betriebs durchgeführt werden. War hingegen das zulässige thermische Energieaufnahmevermögen erreicht, ist die Steuerungseinrichtung 16 dazu ausgebildet, den Schalter 14 so lange geöffnet zu halten, bis der Metalloxidableiter 6 wieder energieaufnahmefähig ist. Dies kann durch einen festen Zeitraum gegeben sein oder aber durch eine bestimmte Temperatur, die der Metalloxidableiter 6 unterschreitet.

In weiteren, nicht näher dargestellten Ausführungsbeispielen können auch noch weitere parallele Strompfade mit jeweils einem Metalloxidableiter und einem Schalter mit Steuerungseinrichtung vorgesehen sein. Die Metalloxidableiter haben dann sukzessive niedrigere Spannungs-Strom-Kennlinien, wobei der Metalloxidableiter 8 ohne Schalter stets die höchste Spannungs-Strom-Kennlinie hat. Hierdurch können mehr als zwei Metalloxidableiter in sukzessiver Folge durch serielles Öffnen der Schalter Energieeinträge aufnehmen.

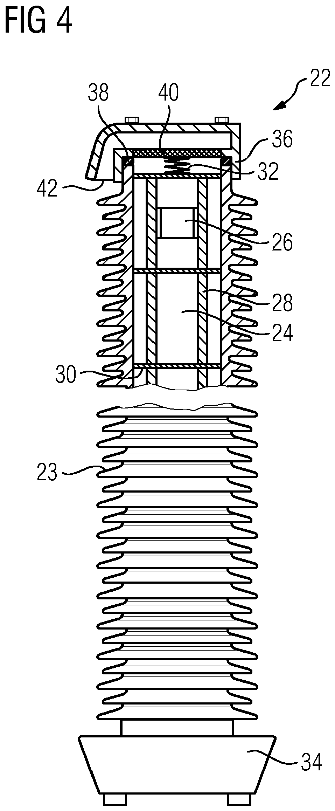

Wie bereits beschrieben kann jeder der Metalloxidableiter 6, 8 selbst aus nur einer Metalloxidableitereinheit bestehen, oder aber selbst Gruppen von mehreren Metalloxidableitereinheiten darstellen, die einander parallel geschaltet sind. Eine solche Metalloxidableitereinheit 22 in Form einer Ableitersäule mit einem Gehäuse 23 aus Porzellan oder einem Verbundwerkstoff wie z. B. GFK (glasfaserverstärkter Kunststoff) für den Einsatz in Hochspannungsnetzen ist in FIG 4 im Teilschnitt dargestellt.

Den eigentlichen Aktivteil der Metalloxidableitereinheit 22 bildet eine zylindrische Säule aus einzelnen, übereinandergestapelten Metalloxid-Widerständen 24. Metalloxid-Widerstände 24 werden fast ausnahmslos in zylindrischer Form gefertigt. Ihr Durchmesser bestimmt maßgeblich das Energieaufnahmevermögen, die Strombelastbarkeit und den Schutzpegel. Er liegt im Bereich von etwa 30 mm für den Einsatz in Mittelspannungsnetzen bis zu 100 mm und mehr für Hoch- und Höchstspannungsnetze und Sonderanwendungen, für die ein hohes Energieaufnahmevermögen gefordert ist.

Die Höhe von MO-Widerständen 24 variiert von etwa 20 mm bis 45 mm. Sie ist im Wesentlichen fertigungsbedingt und hängt von den vorhandenen Werkzeugen und Fertigungseinrichtungen ab. Allerdings lässt sie sich nicht beliebig steigern, da mit zunehmender Höhe (wie auch mit zunehmendem Durchmesser) die Homogenität des Widerstandsmaterials in der Fertigung immer schwerer zu kontrollieren ist. Diese entscheidet aber wesentlich mit über das Energieaufnahmevermögen und vor allem über die Reproduzierbarkeit der spezifizierten technischen Daten.

Die Spannungs-Strom-Kennlinie eines MO-Widerstandes 24 oder auch der kompletten Metalloxidableitereinheit 22 lässt sich auf die Feldstärke-Stromdichte-Kennlinie des zugrunde liegenden Materialsystems, das abhängig von den Inhaltsstoffen und der Fertigungstechnologie ist, zurückführen. Man erhält sie einfach durch Multiplikation der Feldstärke mit der jeweiligen Höhe und der Stromdichte mit der jeweiligen Querschnittsfläche. Damit wird dem Fachmann klar sein, wie er durch konstruktive Maßnahmen die oben geforderten und in FIG 3 dargestellten Spannungs-Strom-Kennlinien 18, 20 erreichen kann.

Mit Hilfe metallischer Füllstücke 26 wird die Länge der Säule an die Gehäuselänge der Metalloxidableitereinheit 22 angepasst. Im einfachsten Fall sind dies Aluminiumrohre, die zur Erzielung eines gleichmäßigen Flächendrucks mit Deckeln abgeschlossen werden. Gelegentlich werden aber auch massive Aluminiumteile eingesetzt, die gleichzeitig als Wärmesenken dienen und damit das thermische Energieaufnahmevermögen des Metalloxidableiters 1 erhöhen.

Die derart aufeinandergestapelten MO-Widerstände 24 werden im Gehäuse mechanisch für Transport und zur Erzielung eines gewissen Kontaktdrucks fixiert. FIG 4 zeigt eine von vielen Realisierungsmöglichkeiten: Mehrere Haltestangen 28 aus GFK-Material umschließen die MO-Widerstandssäule wie einen Käfig. In regelmäßigen Abständen zusätzlich vorgesehene Halteplatten 30 - ebenfalls aus GFK - verhindern einerseits ein Auseinanderbiegen der Haltestangen 28 und begrenzen andererseits ein mögliches Durchbiegen der gesamten Konstruktion in Richtung der Gehäusewand.

Eine am oberen Ende der Säule angreifende starke Druckfeder 32 (bei hohen Anforderungen gegebenenfalls auch mehrere) verspannt den so aufgebauten Aktivteil im Gehäuse 23. Das Gehäuse 23 ist an seinen Enden mit Flanschen 34 aus z. B. Stahl oder Aluminium versehen, die mit Hilfe einer Verbindung 36 aufgebracht sind. Bei einem Gehäuse 23 aus GFK ist die Verbindung 36 als Klebung ausgeführt, bei einem Gehäuse 23 aus Porzellan als Kittung. Für eine derartige Kittung hat sich die Verwendung von Schwefelzement bewährt.

Neben dem Schutz des Aktivteils vor Umwelteinflüssen soll das Gehäuse 23 vor allem auch einen ausreichenden Kriechweg bereitstellen. Es ist hierzu mit Schirmen versehen, die sehr unterschiedlich ausgebildet sein können. Für die Gestaltung des Schirmprofils (Schirmabstände, Schirmausladung, Schirmneigungswinkel) gibt die Anwendungsrichtlinie Reihe IEC 60815 Empfehlungen, die vom Hersteller eingehalten werden sollten.

Die Erläuterungen zu FIG 4 werden nun mit der Beschreibung des Dichtungssystems abgeschlossen. Dieses stellt eine der kritischsten Komponenten einer Metalloxidableitereinheit 22 dar - mit die häufigste in der Ableiterliteratur und von Anwendern genannte Ausfallursache von Ableitern ist Undichtigkeit. Dem Dichtungssystem kommen drei Aufgaben zu, die zum Teil schwer miteinander vereinbar sind: Zum einen soll es für die gesamte Lebensdauer des Ableiters - dabei wird von 25 bis 30 Jahren ausgegangen - das Eindringen von Feuchtigkeit sicher unterbinden, zum anderen soll es eine schnell wirksame Druckentlastungsvorrichtung für den seltenen Fall einer Ableiterüberlastung bilden, bei der sich schlagartig hohe Gehäuse-Innendrücke aufbauen, die andernfalls zum Zerbersten des Gehäusekörpers führen würden. Und schließlich muss an dieser Stelle ein sauberer Stromübergang vom Flansch zur MO-Widerstandssäule sichergestellt werden.

In dem in FIG 4 gezeigten Ausführungsbeispiel besteht das Dichtungssystem im Wesentlichen aus einem Dichtring 38 und der Druckentlastungsmembran 40. Beide Elemente sind zweimal, jeweils an beiden Enden des Gehäuses 23, vorhanden. Der Dichtring 38 liegt auf der Stirnfläche des Gehäusekörpers auf. Erfolgt die Dichtung an dieser Stelle, ist die Verbindung 36 zwischen Flansch 34 und Porzellan nicht in das Dichtsystem einbezogen. Die in dieser Ableiterkonstruktion eingesetzte Druckentlastungsmembran 40 besteht aus einem hochreinen Edelstahl- oder Nickelwerkstoff von nur wenigen Zehntel Millimetern Dicke. Die Membran wird mit einem am Flansch verschraubten metallischen Druckring gegen den Dichtring 38 gepresst.

Im schon erwähnten Fall der Ableiterüberlastung bildet sich ein Teillichtbogen aus, der sich in Sekundenbruchteilen zu einem durchgängigen Lichtbogen im Gehäuseinneren zwischen den beiden Flanschen entwickelt. Durch diesen fließt der volle, sich am Einbauort des Ableiters einstellende Kurzschlussstrom des Netzes (Effektivwert bis zu etwa 80 kA, Scheitelwert bis zu etwa 200 kA). In der Folge kommt es zu einem sprunghaften Druckanstieg innerhalb des Gehäuses 23. Die Druckentlastungsmembranen 40 reißen dabei innerhalb weniger Millisekunden auf und sorgen so für eine sichere Druckentlastung, lange bevor der Berstdruck des Gehäuses 23 erreicht wird. Die heißen, unter starkem Überdruck stehenden Gase treten mit hoher Geschwindigkeit durch die beiden Ausblasöffnungen 42 aus dem Gehäuseinneren.

### Bezugszeichenliste

- 1: Überspannungsableitersystem
- 2: Anordnung
- 4: elektrische Anlage
- 6, 8: Metalloxidableiter
- 10, 12: Strompfad
- 14: Schalter
- 16: Steuerungseinrichtung
- 18, 20: Spannungs-Strom-Kennlinie
- 22: Metalloxidableitereinheit
- 23: Gehäuse
- 24: Metalloxid-Widerstand
- 26: metallisches Füllstück
- 28: Haltestange
- 30: Halteplatte
- 32: Druckfeder
- 34: Flansch
- 36: Verbindung
- 38: Dichtring
- 40: Druckentlastungsmembran
- 42: Ausblasöffnung

## Patentansprüche

1. Überspannungsableitersystem (1) zum Schutz einer elektrischen Anlage (4) vor einer Überspannung oder unzulässigen Energiemenge, umfassend einen ersten Metalloxidableiter (6) in einem ersten Strompfad (10) und einen zweiten Metalloxidableiter (8) in einen zweiten, zum ersten Strompfad (10) parallel geschalteten Strompfad (12),
**dadurch gekennzeichnet, dass**
eine Spannungs-Strom-Kennlinie (18) des ersten Metalloxidableiters (6) in einem Strombereich bei gleichem Strom eine niedrigere Spannung aufweist als eine Spannungs-Strom-Kennlinie (20) des zweiten Metalloxidableiters (8), und der erste Strompfad (10) einen Schalter (14) aufweist.

2. Überspannungsableitersystem (1) nach Anspruch 1, umfassend eine Anzahl weiterer Metalloxidableiter in jeweils einem, zum ersten und zweiten Strompfad (10, 12) parallel geschalteten weiteren Strompfad, wobei die Spannungs-Strom-Kennlinien der weiteren Metalloxidableiter in dem Strombereich bei gleichem Strom sukzessive niedrigere Spannungen aufweisen, und wobei der jeweilige weitere Strompfad jeweils einen Schalter aufweist.

3. Überspannungsableitersystem (1) nach einem der vorhergehenden Ansprüche, bei dem dem jeweiligen Schalter (14) eine Steuerungseinrichtung (16) zugeordnet ist, die dafür ausgelegt ist, den Schalter (14) zu öffnen, wenn der Metalloxidableiter (6) des jeweiligen Strompfads (10) des Schalters (14) eine vorgegebene Energiemenge aufgenommen hat.

4. Überspannungsableitersystem (1) nach einem der vorhergehenden Ansprüche, bei dem Schalter (14) und/oder Steuerungseinrichtung (16) einen niederohmigen und/oder niederinduktiven Aufbau aufweisen.

5. Überspannungsableitersystem (1) nach einem der Ansprüche 3 oder 4, umfassend eine in dem Strompfad (10) des jeweiligen Schalters (14) angeordnete Strom- und/oder Spannungsmesseinrichtung, wobei die dem Schalter (14) zugeordnete Steuerungseinrichtung (16) dafür ausgelegt ist, die dem Metalloxidableiter (6) des Strompfads (10) des Schalters (14) zugeführte Energiemenge anhand der in der Strom- und/oder Spannungsmesseinrichtung gemessenen Werte zu ermitteln.

6. Überspannungsableitersystem (1) nach einem der Ansprüche 3 bis 5, umfassend eine in dem jeweiligen Metalloxidableiter (6) angeordnete Temperaturmesseinrichtung, wobei die dem Schalter (14) des Strompfads (10) des Metalloxidableiters (6) zugeordnete Steuerungseinrichtung (16) dafür ausgelegt ist, die dem Metalloxidableiter (6) zugeführte Energiemenge anhand der in der Temperaturmesseinrichtung gemessenen Werte zu ermitteln.

7. Überspannungsableitersystem (1) nach einem der vorhergehenden Ansprüche, bei dem der Strombereich zwischen 0,001 kA und 100 kA liegt.

8. Überspannungsableitersystem (1) nach einem der vorhergehenden Ansprüche, bei dem der Strombereich zwischen 0,1 kA und 10 kA liegt.

9. Überspannungsableitersystem (1) nach einem der vorhergehenden Ansprüche, bei dem der Spannungsunterschied der Spannungs-Strom-Kennlinie (18, 20) zweier Metalloxidableiter (6, 8) mindestens 1 kV bei gleichem Strom beträgt.

10. Überspannungsableitersystem (1) nach einem der vorhergehenden Ansprüche, bei dem ein Metalloxidableiter (6, 8) eine Mehrzahl von parallel geschalteten Metalloxidableitereinheiten (22) umfasst.

11. Anordnung (2), umfassend eine elektrische Anlage (4) und ein der elektrischen Anlage (4) parallel geschaltetes Überspannungsableitersystem (1) nach einem der vorhergehenden Ansprüche.

## Claims

1. Overvoltage arrester system (1) for the protection of an electrical installation (4) against an overvoltage or impermissible amount of energy, comprising a first metal oxide arrester (6) in a first current path (10) and a second metal oxide arrester (8) in a second current path (12) connected in parallel with the first current path (10),
**characterized in that**
a characteristic voltage-current curve (18) of the first metal oxide arrester (6) exhibits a lower voltage in a current region with the same current than a characteristic voltage-current curve (20) of the second metal oxide arrester (8), and the first current path (10) comprises a switch (14).

2. Overvoltage arrester system (1) according to Claim 1, comprising a number of further metal oxide arresters, each in a further current path connected in parallel with the first and second current paths (10, 12), wherein the characteristic voltage-current curves of the further metal oxide arresters exhibit successively lower voltages in the current range at the same current, and wherein each respective further current path comprises a switch.

3. Overvoltage arrester system (1) according to either of the previous claims, in which a control device (16) is assigned to the respective switch (14), and is designed to open the switch (14) when the metal oxide arrester (6) of the respective current path (10) of the switch (14) has absorbed a predetermined amount of energy.

4. Overvoltage arrester system (1) according to one of the previous claims, in which the switch (14) and/or control device (16) has a low-resistance and/or low-inductance construction.

5. Overvoltage arrester system (1) according to either of Claims 3 and 4, comprising a current and/or voltage measuring device arranged in the current path (10) of the respective switch (14), where the control device (16) assigned to the switch (14) is designed to determine the amount of energy supplied to the metal oxide arrester (6) of the current path (10) of the switch (14) on the basis of the values measured in the current and/or voltage measuring device.

6. Overvoltage arrester system (1) according to one of Claims 3 to 5, comprising a temperature measuring device arranged in the respective metal oxide arrester (6), where the control device (16) assigned to the switch (14) of the current path (10) of the metal oxide arrester (6) is designed to determine the amount of energy supplied to the metal oxide arrester (6) on the basis of the values measured in the temperature measuring device.

7. Overvoltage arrester system (1) according to one of the previous claims, in which the current range lies between 0.001 kA and 100 kA.

8. Overvoltage arrester system (1) according to one of the previous claims, in which the current range lies between 0.1 kA and 10 kA.

9. Overvoltage arrester system (1) according to one of the previous claims, in which the voltage difference between the characteristic voltage-current curves (18, 20) of two metal oxide arresters (6, 8) is at least 1 kV at the same current.

10. Overvoltage arrester system (1) according to one of the previous claims, in which the metal oxide arrester (6, 8) comprises a plurality of metal oxide arrester units (22) connected in parallel.

11. Arrangement (2) comprising an electrical installation (4) and an overvoltage arrester system (1) according to one of the previous claims connected in parallel with the electrical installation (4).

## Revendications

1. Système (1) de parafoudre pour protéger une installation (4) électrique d'une surtension ou d'une quantité d'énergie inadmissible, comprenant un premier parafoudre en oxyde métallique dans un premier trajet (10) de courant et un deuxième parafoudre (8) en oxyde métallique dans un deuxième trajet (12) de courant parallèle au premier trajet (10) de courant,
**caractérisé en ce que**
une courbe caractéristique (18) tension-courant du premier parafoudre (6) en oxyde métallique a, dans une plage de courant, pour un même courant, une tension plus basse qu'une courbe caractéristique (20) tension-courant du deuxième parafoudre (8) en oxyde métallique, et le premier trajet (10) de courant a un interrupteur (14).

2. Système (1) de parafoudre suivant la revendication 1, comprenant un certain nombre d'autres parafoudres en oxyde métallique dans, respectivement, un autre trajet de courant parallèle aux premier et au deuxième trajets (10, 12) de courant, les courbes caractéristiques tension-courant des autres parafoudres en oxyde métallique ayant, dans la plage de courant, pour un même courant, des tensions successives plus basses et dans lequel l'autre trajet de courant respectif a, respectivement, un interrupteur.

3. Système (1) de parafoudre suivant l'une des revendications précédentes, dans lequel, à l'interrupteur (14) respectif est affecté un dispositif (16) de commande, conçu pour ouvrir l'interrupteur (14), si le parafoudre (6) en oxyde métallique du trajet (10) de courant respectif de l'interrupteur (14) a absorbé une quantité d'énergie donnée à l'avance.

4. Système (1) de parafoudre suivant l'une des revendications précédentes, dans lequel l'interrupteur (14) et/ou le dispositif (16) de commande ont une structure à basse valeur ohmique et/ou à basse valeur inductive.

5. Système (1) de parafoudre suivant l'une des revendications 3 ou 4, comprenant un dispositif de mesure du courant et/ou de la tension, monté dans le trajet (10) de courant de l'interrupteur (14) respectif, dans lequel le dispositif (16) de commande, affecté à l'interrupteur (14), est conçu pour déterminer, à l'aide des valeurs mesurées dans le dispositif de mesure du courant et/ou de la tension, la quantité d'énergie apportée au parafoudre (6) en oxyde métallique du trajet (10) de courant de l'interrupteur (14).

6. Système (1) de parafoudre suivant l'une des revendications 3 à 5, comprenant un dispositif de mesure de la température, monté dans le parafoudre (6) en oxyde métallique respectif, le dispositif (16) de commande, affecté à l'interrupteur (14) du trajet (10) de courant du parafoudre (6) en oxyde métallique, étant conçu pour déterminer, à l'aide des valeurs mesurées dans le dispositif de mesure de la température, la quantité d'énergie apportée au parafoudre (6) en oxyde métallique.

7. Système (1) de parafoudre suivant l'une des revendications précédentes, dans lequel la plage de courant est comprise entre 0,001 kA et 100 kA.

8. Système (1) de parafoudre suivant l'une des revendications précédentes, dans lequel la page de courant est comprise entre 0,1 kA et 10 kA.

9. Système (1) de parafoudre suivant l'une des revendications précédentes, dans lequel la différence de tension des deux courbes caractéristiques (18, 20) tension-courant de deux parafoudres (6, 8) en oxyde métallique est d'au moins 1 kV pour un même courant.

10. Système (1) de parafoudre suivant l'une des revendications précédentes, dans lequel un parafoudre (6, 8) en oxyde métallique comprend une pluralité d'unités (22) de parafoudre en oxyde métallique montées en parallèle.

11. Agencement (2), comprenant une installation (4) électrique et un système (1) de parafoudre suivant l'une des revendications précédentes, montés en parallèle à l'installation (4) électrique.
